# EUROPEAN PATENT APPLICATION

(11) **EP 4 589 934 A1**
(43) Date of publication of application: **23.07.2025**
(21) Application number: 23882993.1
(22) Date of filing: 18.10.2023
(51) Int. Cl.: H04M 1/02, H02J 7/00, H01R 12/71, H01M 50/249, H01M 10/46

(54) **ELECTRONIC DEVICE COMPRISING COMMUNICATION CIRCUIT AND CONNECTOR**

(30) Priority: 28.10.2022 KR 20220141845; 15.11.2022 KR 20220152806
(71) Applicant: Samsung Electronics Co., Ltd., Suwon-si, Gyeonggi-do 16677 (KR)
(72) Inventor: YOO, Changhee, Suwon-si Gyeonggi-do 16677 (KR); RYU, Kyungmin, Suwon-si Gyeonggi-do 16677 (KR); JANG, Gyudae, Suwon-si Gyeonggi-do 16677 (KR); CHO, Sujeong, Suwon-si Gyeonggi-do 16677 (KR)
(74) Representative: Gulde & Partner
(86) International application number: PCT/KR2023/016169
(87) International publication number: WO 2024/090886

(57) **Abstract**

This electronic device may comprise: a housing; a circuit board arranged in the housing and including a ground layer; a battery arranged in the housing and including a protection circuit configured to control charging; a communication circuit attached on the circuit board; a first connector arranged on the circuit board and electrically connected to the protection circuit; and a second connector arranged on the circuit board and spaced apart from the first connector. The second connector may be closer to the communication circuit than to the first connector. The second connector may be electrically connected to the ground layer of the circuit board or the battery.

## Description

### [Technical Field]

Various embodiments of the disclosure relate to an electronic device including a communication circuit and a connector.

### [Background Art]

Along with the development of information and communication technology and semiconductor technology, various functions are integrated into a single electronic device. For example, in addition to a communication function, an entertainment function such as games, a multimedia function such as music/video playback, a communication and security function for mobile banking, and a function such as schedule management or an electronic wallet may be implemented in an electronic device. Such an electronic device is being miniaturized so that a user may conveniently carry it.

### [Detailed Description of the Invention]

### [Technical Solution]

According to an embodiment of the disclosure, an electronic device may include a housing, a circuit board disposed within the housing and including a ground layer, a battery disposed within the housing and including a protection circuit configured to control charging, a communication circuit attached on the circuit board, a first connector disposed on the circuit board and electrically connected to the protection circuit, and a second connector disposed on the circuit board and spaced apart from the first connector. The second connector may be closer to the communication circuit than the first connector. The second connector may be electrically connected to the ground layer of the circuit board or the battery.

According to an embodiment of the disclosure, an electronic device may include a housing, a circuit board disposed within the housing and including a ground layer, a battery including a protection circuit configured to control charging, a communication circuit attached on the circuit board, a first connector disposed on the circuit board and electrically connected to the protection circuit, and a second connector spaced apart from the first connector and connected to the ground layer. The communication circuit may be closer to the second connector than to the first connector. The protection circuit may be closer to the first connector than to the second connector.

### [Brief Description of Drawings]

FIG. 1 is a block diagram illustrating an electronic device in a network environment according to an embodiment of the disclosure.
FIG. 2 is a front perspective view illustrating an electronic device according to an embodiment of the disclosure.
FIG. 3 is a rear perspective view illustrating an electronic device according to an embodiment of the disclosure.
FIG. 4 is an exploded perspective view illustrating an electronic device according to an embodiment of the disclosure.
FIGS. 5A, 5B, and 5C are schematic diagrams illustrating an electronic device including a communication circuit, a first connector, a second connector, and a circuit board according to an embodiment of the disclosure.
FIG. 6 is a front view illustrating a circuit board on which a second connector is located according to an embodiment of the disclosure.
FIGS. 7A, 7B, and 7C are schematic diagrams illustrating an electronic device including a communication circuit, a first connector, a second connector, and a circuit board according to an embodiment of the disclosure.
FIG. 8 is a circuit diagram including a battery, a charging circuit, a first connector, and a second connector according to an embodiment of the disclosure.
FIGS. 9A, 9B and 9C are rear views illustrating an electronic device including a second connector according to an embodiment of the disclosure.

### [Mode for Carrying out the Invention]

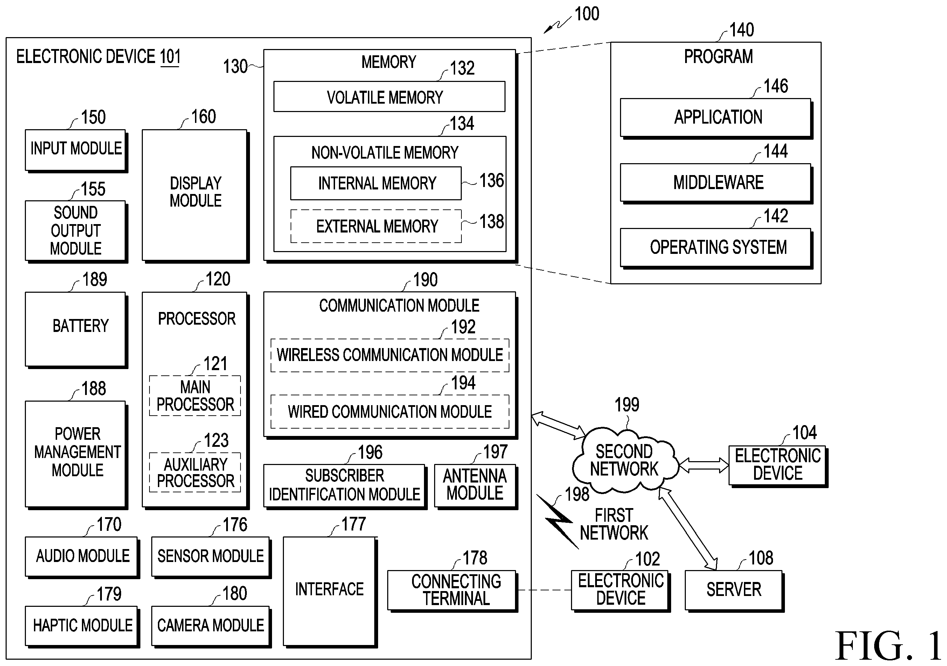

FIG. 1 is a block diagram illustrating an electronic device in a network environment according to an embodiment of the disclosure.

Referring to FIG. 1, an electronic device 101 in a network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the strength of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., the electronic device 102) (e.g., a speaker or headphone) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

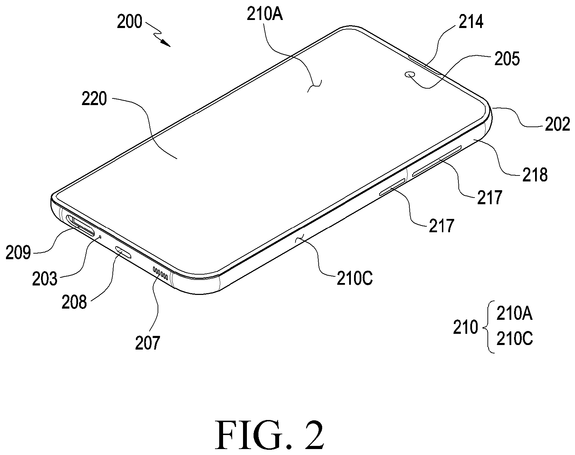

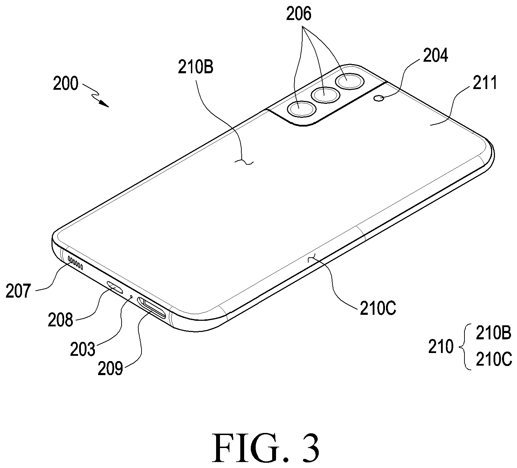

FIG. 2 is a front perspective view illustrating an electronic device according to an embodiment of the disclosure. FIG. 3 is a rear perspective view illustrating an electronic device according to an embodiment of the disclosure.

Referring to FIGS. 2 and 3, an electronic device 200 (e.g., the electronic device of FIG. 1) according to an embodiment may include a housing 210 which includes a front surface 210A, a rear surface 210B, and a side surface 210C surrounding a space between the front surface 210A and the rear surface 210B. In another embodiment (not shown), the housing 210 may refer to a structure that forms a portion of the front surface 210A of FIG. 2, the rear surface 210B of FIG. 3, and the side surface 210C. For example, the housing 210 may include a front plate 202 and a rear plate 211. According to an embodiment, at least a portion of the front surface 210A may be formed by the front plate 202 (e.g., a glass plate or polymer plate including various coating layers) at least a portion of which is substantially transparent. The rear plate 211 may be formed of, for example, glass, ceramic, a polymer, a metal (e.g., titanium (Ti), stainless steel (STS), aluminum (Al), and/or magnesium (Mg)), or a combination of at least two of these materials. The side surface 210C may be coupled to the front plate 202 and the rear plate 211 and formed by a side bezel structure (or 'side member') 218 including a metal and/or a polymer. In some embodiments, the rear plate 211 and the side bezel structure 218 may be integrally formed and include the same material (e.g., glass, a metal material such as aluminum, or ceramic). In another embodiment, the front surface 210A and/or the front plate 202 may be interpreted as a portion of a display 220.

According to an embodiment, the electronic device 200 may include at least one of the display 220, audio modules 203, 207, and 214 (e.g., the audio module 170 of FIG. 1), a sensor module (e.g., the sensor module 176 of FIG. 1), camera modules 205 and 206 (e.g., the camera module 180 of FIG. 1), key input devices 217 (e.g., the input module 150 of FIG. 1), or connector holes 208 and 209 (e.g., the connecting terminal 178 of FIG. 1). In some embodiment, the electronic device 200 may not be provided with at least one (e.g., the connector hole 209) of the components or may additionally include other components. According to an embodiment, the display 220 may be visually exposed, for example, through a substantial portion of the front plate 202.

According to an embodiment, a surface (or the front plate 202) of the housing 210 may include a screen display area formed by visual exposure of the display 220. For example, the screen display area may include the front surface 210A.

According to an embodiment, a recess or an opening may be formed in a portion of the screen display area (e.g., the front surface 210A) of the display 220, and at least one of the audio module 214, a sensor module (not shown), a light emitting element (not shown), or the camera module 205, which is aligned with the recess or the opening, may be included. In another embodiment (not shown), at least one of the audio module 214, the sensor module (not shown), the camera module 205, a fingerprint sensor (not shown), or the light emitting element (not shown) may be included on the rear surface of the screen display area of the display 220.

According to an embodiment, the display 220 may be incorporated with or disposed adjacent to a touch sensing circuit, a pressure sensor capable of measuring the intensity (pressure) of a touch, and/or a digitizer that detects a magnetic field-based stylus pen.

According to an embodiment, the audio modules 203, 207, and 214 may include, for example, a microphone hole 203 and speaker holes 207 and 214. A microphone for obtaining an external sound may be disposed in the microphone hole 203, and in an embodiment, a plurality of microphones may be disposed to detect the direction of a sound. The speaker holes 207 and 214 may include an external speaker hole 207 and a receiver hole 214 for calls. In an embodiment, the speaker holes 207 and 214 and the microphone hole 203 may be implemented as a single hole, or a speaker (e.g., a piezo speaker) may be included without the speaker holes 207 and 214.

According to an embodiment, the sensor module (not shown) may generate an electrical signal or data value corresponding to an internal operation state of the electronic device 101 or an external environmental state. The sensor module (not shown) may include, for example, a first sensor module (not shown) (e.g., a proximity sensor) and/or a second sensor module (not shown) (e.g., a fingerprint sensor), disposed on the front surface 210A of the housing 210. The sensor module (not shown) may include a third sensor module (not shown) (e.g., a HRM sensor) and/or a fourth sensor module (not shown) (e.g., a fingerprint sensor), disposed on the rear surface 210B of the housing 210. In some embodiments (not shown), the fingerprint sensor may be disposed on the rear surface 210B as well as on the front surface 210A (e.g., the display 220) of the housing 210. The electronic device 101 may further include a sensor module which is not shown, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor (not shown).

According to an embodiment, the camera modules 205 and 206 may include a front camera module 205 disposed on the front surface 210A of the electronic device 200, and a rear camera module 206 and/or a flash 204 disposed on the rear surface 210B of the electronic device 200. The camera modules 205 and 206 may include one or more lenses, an image sensor, and/or an image signal processor. The flash 204 may include, for example, a light emitting diode (LED) or a xenon lamp. In some embodiments, two or more lenses (an IR camera, a wide-angle lens, and a telephoto lens) and image sensors may be arranged on one surface of the electronic device 200.

According to an embodiment, the key input devices 217 may be arranged on the side surface 210C of the housing 210. In another embodiment, the electronic device 200 may not include some or any of the key input devices 217, and the key input devices 217 which are not included may be implemented in other forms such as soft keys on the display 220. According to an embodiment, at least some of the key input devices may be disposed on the side bezel structure 218.

According to an embodiment, the light emitting element (not shown) may be disposed, for example, on the front surface 210A of the housing 210. The light emitting element (not shown) may provide, for example, state information about the electronic device 200 in the form of light. In another embodiment, the light emitting element (not shown) may provide, for example, a light source interworking with an operation of the front camera module 205. The light emitting element (not shown) may include, for example, an LED, an IR LED, and/or a xenon lamp.

According to an embodiment, the connector holes 208 and 209 may include a first connector hole 208 capable of accommodating a connector (e.g., a USB connector) for transmitting and receiving power and/or data to and from an external electronic device and/or a second connector hole 209 capable of accommodating a storage device (e.g., a subscriber identification module (SIM) card). According to an embodiment, the first connector hole 208 and/or the second connector hole 209 may be omitted.

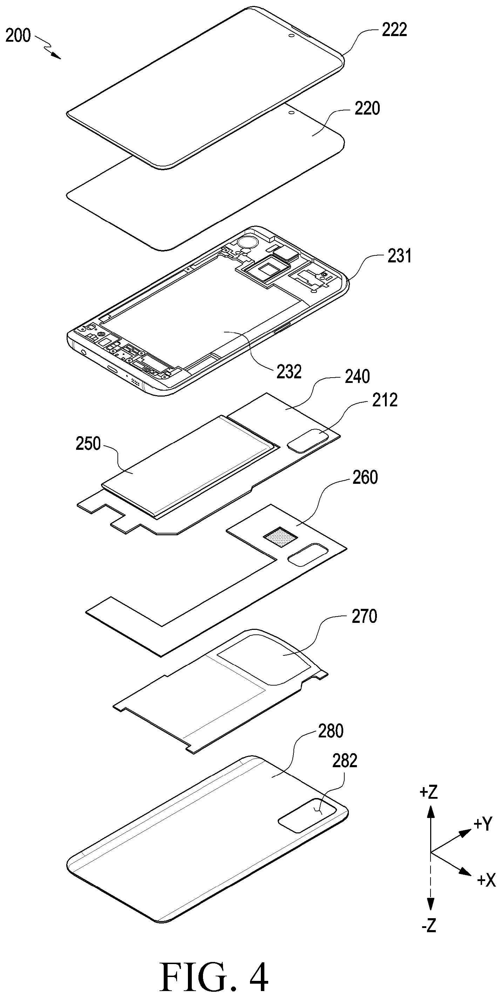

FIG. 4 is an exploded perspective view illustrating an electronic device according to an embodiment of the disclosure.

Referring to FIG. 4, the electronic device 200 (e.g., the electronic device 200 of FIGS. 2 and 3) may include at least one of a front plate 222 (e.g., the front plate 202 of FIG. 2), the display 220 (e.g., the display 220 of FIG. 2), a bracket 232 (e.g., a front support member), a PCB 240, a battery 250, a rear case 260 (e.g., a rear support member), an antenna 270, or a rear plate 280 (e.g., the rear plate 211 of FIG. 3). According to an embodiment, the electronic device 200 may not be provided with at least one (e.g., the rear case 260) of the components or may additionally include other components. At least one of the components of the electronic device 200 may be the same as or similar to at least one of the components of the electronic device 200 of FIG. 2 or FIG. 3, and a redundant description will be avoided herein.

According to various embodiments, the bracket 232 may be disposed inside the electronic device 200 and connected to a side bezel structure 231, or may be integrally formed with the side bezel structure 231. The bracket 232 may be formed of, for example, a metal material and/or a non-metal (e.g., polymer) material. The bracket 232 may accommodate the display 220 on one surface thereof and the PCB 240 on the other surface thereof. A processor (e.g., the processor 120 of FIG. 1), memory (e.g., the memory 130 of FIG. 1), and/or an interface (e.g., the interface 177 of FIG. 1) may be mounted on the PCB 240.

According to an embodiment, the battery 250, which is a device for supplying power to at least one component of the electronic device 200, may include, for example, a non-rechargeable primary cell, a rechargeable secondary cell, or a fuel cell. At least a portion of the battery 250 may be disposed substantially on the same plane with the PCB 240, for example. The battery 250 may be disposed integrally inside the electronic device 200 or disposed detachably from the electronic device 200.

According to various embodiments, the rear case 260 may be disposed between the PCB 240 and the antenna 270. For example, the rear case 260 may include one surface coupled to at least one of the PCB 240 or the battery 250 and the other surface coupled to the antenna 270.

According to an embodiment, the antenna 270 may be disposed between the rear plate 280 and the battery 250. The antenna 270 may include, for example, a near field communication (NFC) antenna, a wireless charging antenna, and/or a magnetic secure transmission (MST) antenna. The antenna 270 may, for example, perform short-range communication with an external device or wirelessly transmit and receive power for charging to and from an external device. For example, the antenna 270 may include a coil for wireless charging. In an embodiment, an antenna structure may be formed by a portion or combination of the side bezel structure 231 and/or the bracket 232.

According to an embodiment, the electronic device 200 may include a camera module 212 disposed within the housing (e.g., the housing 210 of FIG. 2). According to an embodiment, the camera module 212 may be disposed on the bracket 232, and may be a rear camera module (e.g., the camera module 212 of FIG. 3). According to an embodiment, at least a portion of the camera module 212 may be exposed to the outside of the electronic device 200 through an opening 282 formed on the rear plate 280.

The electronic device 200 disclosed in FIGS. 2 to 4 has a bar-type or plate-type appearance, to which the disclosure is not limited. For example, the illustrated electronic device may be a rollable electronic device or a foldable electronic device. The term "rollable electronic device" may refer to an electronic device in which a display (e.g., the display 220 of FIG. 4) is bendable, so that at least a portion thereof is wound or rolled or is accommodated into a housing (e.g., the housing 210 of FIG. 2). Depending on the needs of a user, the rollable electronic device may be used by unfolding a display or exposing a wider area of the display to the outside to extend a screen display area.

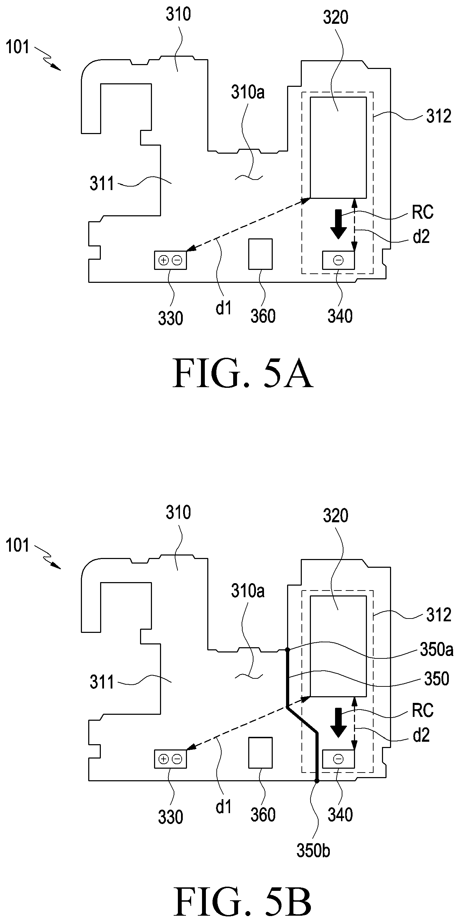

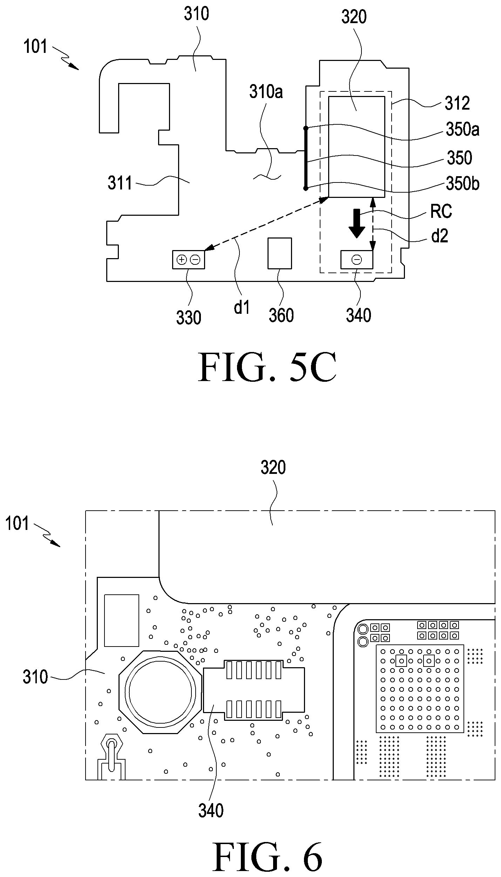

FIGS. 5A, 5B, and 5C are schematic diagrams illustrating an electronic device including a communication module, a first connector, a second connector, and a circuit board according to an embodiment of the disclosure.

Referring to FIG. 5A, 5B, and/or 5C, the electronic device 101 may include a circuit board 310, a communication circuit 320, a first connector 330, and a second connector 340. The configurations of the circuit board 310 and the communication circuit 320 of FIG. 5A, 5B, and/or 5C may be wholly or partially the same as the configurations of the PCB 240 of FIG. 4 and the communication module 190 of FIG. 1.

According to an embodiment, the circuit board 310 may accommodate components (e.g., the communication circuit 320, the first connector 330, and/or the second connector 340) of the electronic device 101. For example, the circuit board 310 may include a surface 310a on which the communication circuit 320 and a connector (e.g., the first connector 330 and/or the second connector 340) are mounted.

According to an embodiment, the circuit board 310 may include a first area 311 that accommodates the first connector 330 and a second area 312 that accommodates the second connector 340. Each of the first area 311 and the second area 312 may be referred to as a portion of the circuit board 310. In an embodiment, the first area 311 may accommodate an analog component of the electronic device 101. For example, operational stability may be improved by positioning a component that may be affected by noise due to a return current RC at a location excluded from a path of the return current RC. According to an embodiment, the second area 312 may provide the path of the return current RC. For example, the second area 312 may be a portion of the circuit board 310 that accommodates the communication circuit 320 and the second connector 340. According to an embodiment, the second area 312 may accommodate a digital component of the electronic device 101. For example, design ease may be improved by positioning a digital component that is relatively less likely to be affected by noise due to the return current RC in the path of the return current RC. At least a portion of the second area 312 may be referred to as a return current path.

According to an embodiment, a component (e.g., an analog circuit 360) that may generate noise due to the return current RC may be disposed at a location separated from the return current path. For example, at least a portion of the analog circuit 360 may be disposed on a surface of the first area 311 or inside the first area 311. According to an embodiment, the analog circuit 360 may be selectively disposed. For example, the analog circuit 360 may be located in a space (e.g., an internal area of the housing 210) excluding the second area 312. According to an embodiment, at least a portion of the analog circuit 360 may be located between the first connector 330 and the second connector 340.

According to an embodiment, at least some of the components mounted on the circuit board 310 may be located in the path of the return current generated from the communication circuit 320. For example, a digital component using a discrete signal may be less affected by the return current RC than the analog circuit 360. Since the digital component is located in the return current path (e.g., in a space between the communication circuit 320 and the second connector 340), the design ease of the circuit board 310 may be improved.

According to an embodiment, the configuration of the communication circuit 320 may be wholly or partially the same as the configuration of the communication module 190 and/or the antenna module 197 in FIG. 1. According to an embodiment, the communication circuit 320 may be a radio frequency integrated circuit (RFIC). The communication circuit 320 may include a wireless communication module (e.g., a cellular communication module, a short-range wireless communication module, or a global navigation satellite system (GNSS) communication module) and/or a power amplifier. According to an embodiment, the communication circuit 320 may be referred to as a radio transceiver (e.g., a receiver) or an RFIC. The communication circuit 320 may receive power from a battery (e.g., the battery 289 of FIG. 4). The communication circuit 320 may be applied selectively. For example, the communication circuit 320 is not limited in type as long as it is a component consuming power received from the battery 289.

According to an embodiment, the return current RC may be generated in the communication circuit 320 of the electronic device 101. For example, at least a portion of a current transmitted to the communication circuit 320 may return to a source (e.g., the battery 289 of FIG. 4).

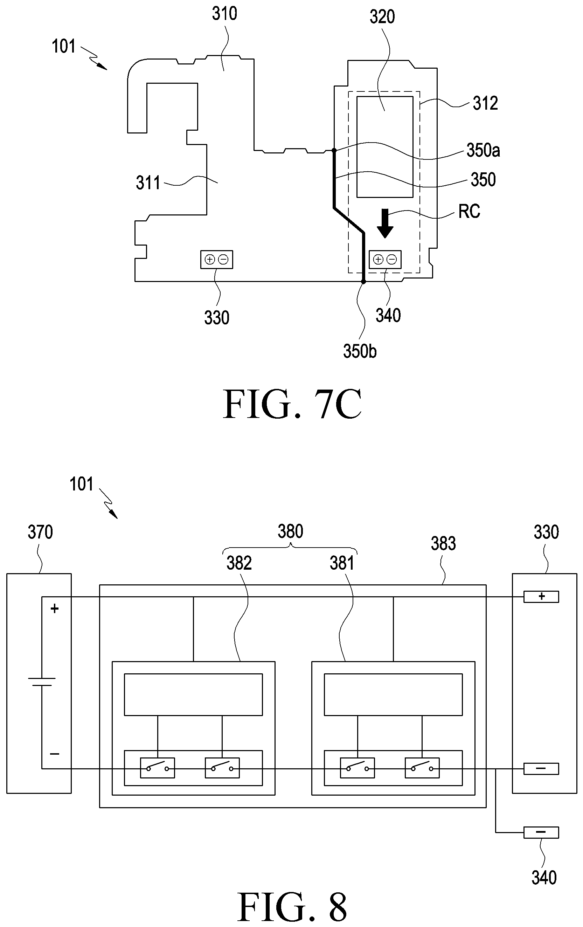

According to an embodiment, the first connector 330 may be electrically connected to the battery (e.g., the battery 250 of FIG. 4 and/or a battery 370 of FIG. 8). For example, the first connector 330 may transmit a current supplied from the battery 370 to an electronic component (e.g., the communication circuit 320) through a wiring located on the circuit board 310. The first connector 330 may be referred to as a battery connector.

According to an embodiment, although the first connector 330 is referred to as a connector, this is optional. For example, the first connector 330 may include a connector including a plurality of pins, a cable structure, a plug, or a pad. According to an embodiment, the first connector 330 may be referred to as a first conductive pad.

According to an embodiment, the second connector 340 may provide a path for the return current RC generated from the communication circuit 320. The second connector 340 may be closer to the communication circuit 320 than the first connector 330. For example, a first distance d1 between the first connector 330 and the communication circuit 320 may be larger than a second distance d2 between the second connector 340 and the communication circuit 320. Since the second connector 340 is closer to the communication circuit 320 than the first connector 330, at least a portion of the return current RC generated from the communication circuit 320 may be transmitted to the second connector 340. When a high-speed signal is transmitted from the circuit board 310, the return current RC may return to the source (e.g., the battery) through the second connector 340.

According to an embodiment, since the communication circuit 320 and the second connector 340 are close, the length of the return current path may be reduced. As the length for which the return current RC flows is reduced, the impact of the return current RC on the components mounted on the circuit board 310 may be reduced. In an embodiment, the magnitude of the return current RC transmitted from the communication circuit 320 to the second connector 340 may be greater than the magnitude of the return current RC transmitted from the communication circuit 320 to the first connector 330. The magnitude of the return current RC may be a current intensity.

In an embodiment, the second connector 340 may be electrically connected to a ground layer of the circuit board 310. For example, the second connector 340 may be connected to the ground layer using a via of the circuit board 310. At least a portion of the return current RC may be transmitted to the ground layer of the circuit board 310 through the surface 310a of the circuit board 310 (e.g., the second area 312) and the second connector 340. In an embodiment, the second connector 340 may be referred to as a ground connector.

In an embodiment, although the second connector 340 is referred to as a connector, this is optional. For example, the second connector 340 may include a connector including a plurality of pins, a cable structure, a plug, or a pad. In an embodiment, the second connector 340 may be referred to as a second conductive pad.

In an embodiment, the electronic device 101 may include an insulating area 350 for electrically isolating at least a portion of the circuit board 310. In an embodiment, the insulating area 350 may electrically isolate a ground (e.g., the ground layer) or conductive portion of the circuit board 310. For example, the insulating area 350 may electrically isolate the first area 311 and the second area 312 from each other. The insulating area 350 may electrically separate one layer of the circuit board 310 where the first area 311 is located from another layer of the circuit board 310. The insulating area 350 may reduce the magnitude of the return current RC transmitted to the first connector 330 and/or the analog circuit 360. The circuit board 310 on which the insulating area 350 is formed may be referred to as a circuit board 310 including a slit. The insulating area 350 may be an area of the circuit board 310 from which a conductor has been removed. For example, a portion of the circuit board 310 from which copper foil is removed in the conductive portion (e.g., the ground layer of the circuit board 310 by etching may be referred to as the insulating area 350.

According to an embodiment, at least a portion of the insulating area 350 may be located between the first connector 330 and the communication circuit 320. The magnitude of the return current RC transmitted to the first connector 330 may be reduced due to the insulating area 350. At least a portion of the insulating area 350 may be located between the first area 311 and the second area 312 of the circuit board 310. At least a portion of the insulating area 350 may be located between the first connector 330 and the second connector 340.

According to an embodiment, the insulating area 350 may include a first end 350a and a second end 350b opposite to the first end 350a. In an embodiment (e.g., FIG. 5B), the first end 350a of the insulating area 350 may be connected to or located at one edge of the circuit board 310, and the second end 350b of the insulating area 350 may be connected to or located at another edge of the circuit board 310. For example, the insulating area 350 may electrically isolate one portion of the circuit board 310 from another portion. In an embodiment (e.g., FIG. 5C), the first end 350a of the insulating area 350 may be connected to one edge of the circuit board 310, and the second end 350b may be spaced apart from the edge of the circuit board 310. The shape of the insulating area 350 is exemplary. For example, the shape of the insulating area 350 may be changed according to the structure of a component accommodated on the circuit board 310.

According to an embodiment, the circuit board 310 may provide a reference potential. For example, the circuit board 310 may include the ground layer. The ground layer may be referred to as a conductive portion located within at least one layer of the circuit board 310. In an embodiment, the second connector 340 may be connected to the ground layer of the circuit board 310 through a via. For example, at least a portion of the return current RC may be transmitted to the ground layer of the circuit board 310 through the second connector 340. In an embodiment, the ground layer of the circuit board 310 may be referred to as a ground in the disclosure.

FIG. 6 is a front view illustrating a circuit board on which a second connector is located according to an embodiment of the disclosure.

Referring to FIG. 6, the electronic device 101 may include the circuit board 310 and the second connector 340. The configurations of the circuit board 310 and the second connector 340 of FIG. 6 may be wholly or partially the same as the configurations of the circuit board 310 and the second connector 340 of FIGS. 5 to 7. According to an embodiment, the structure of the electronic device 101 of FIG. 6 may be applied to the foregoing embodiment (e.g., the electronic device 101 of FIG. 5A or FIG. 5C).

According to an embodiment, the second connector 340 may be a connector used for debugging an AP (e.g., the processor 120 of FIG. 1). According to an embodiment, the second connector 340 may be a joint test action group (JTAG) connector. JTAG may be referred to as a method of transmitting output data or receiving input data in a serial communication scheme for digital input/output of a specific node in a digital circuit.

According to an embodiment, the second connector 340 may be used as a JTAG connector for debugging and/or as a radio frequency ground of the communication circuit 320. The stability of components accommodated on the circuit board 310 may be increased and the design ease of the circuit board 310 may be improved by using the JTAG connector as a path for the return current generated from the communication circuit 320. According to an embodiment, a ground pin of the second connector 340 may be connected to the battery (e.g., the battery 250 of FIG. 4), while the other pins may be not connected to the battery 250.

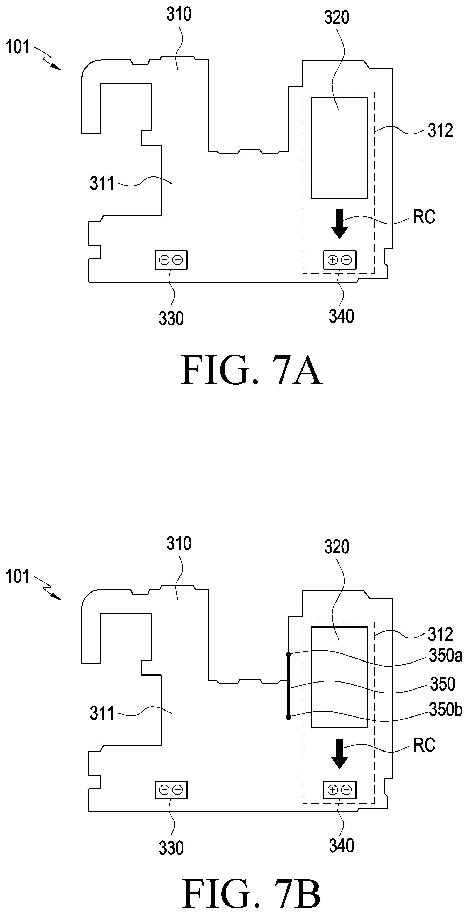

FIGS. 7A, 7B, and 7C are schematic diagrams illustrating an electronic device including a communication module, a first connector, a second connector, and a circuit board according to an embodiment of the disclosure. FIG. 8 is a circuit diagram including a battery, a protection circuit, a first connector, and a second connector according to an embodiment of the disclosure.

Referring to FIG. 7A, FIG. 7B, FIG. 7C, and/or FIG. 8, the electronic device 101 may include the circuit board 310, the communication circuit 320, the first connector 330, the second connector 340, and the insulating area 350. The configurations of the circuit board 310, the communication circuit 320, the first connector 330, the second connector 340, and the insulating area 350 of 7A, FIG. 7B, FIG. 7C, and/or FIG. 8 may be wholly or partially the same as the configurations of the circuit board 310, the communication circuit 320, the first connector 330, the second connector 340, and the insulating area 350 of FIGS. 5A, 5B, and 5C.

According to an embodiment, the electronic device 101 may include the battery 370 (e.g., the battery 189 of FIG. 1 or the battery 250 of FIG. 4). The battery 370 may supply power to the components of the electronic device 101 through the first connector 330.

According to an embodiment, the electronic device 101 may include a protection circuit 380. According to an embodiment, the protection circuit 380 may control charging of the battery 370. For example, the configuration of the protection circuit 380 may be wholly or partially the same as the configuration of a power management module (e.g., the power management module 188 of FIG. 1). According to an embodiment, the protection circuit 380 may be included in the battery 370. For example, the battery 370 may be referred to as a structure including the protection circuit 380 and a cell or electrode assembly (e.g., a positive electrode and/or a negative electrode).

According to an embodiment, the protection circuit 380 may be referred to as a protection circuit module (PCM). For example, the protection circuit 380 may perform an overcharge protection, overdischarge protection, overcurrent blocking, and/or short-circuit protection function for the battery 370. According to an embodiment, the protection circuit 380 may be mounted on a protection circuit board 383. The protection circuit board 383 may be referred to as a protection circuit module printed circuit board (PCM PCB). The protection circuit board 383 may be separated from the circuit board 310. According to an embodiment, the protection circuit 380 may include a battery management system (BMS). For example, the protection circuit 380 may predict a charging state of the battery 370 and manage heat generation of the battery 370.

According to an embodiment, the protection circuit 380 may be located closer to the first connector 330 than to the second connector 340. For example, the distance between the protection circuit 380 and the first connector 330 may be smaller than the distance between the protection circuit 380 and the second connector 340. The protection circuit 380 may be disposed within the housing (e.g., the housing 210 of FIG. 2) of the electronic device 101.

According to an embodiment, the protection circuit 380 may include a plurality of protection circuits (e.g., a first protection circuit 381 and a second protection circuit 382). In an embodiment, the protection circuit 380 may include a test point located between the first protection circuit 381 and the second protection circuit 392.

According to an embodiment, the first connector 330 and the second connector 340 may be battery connectors. The battery 370 and the protection circuit 380 may be electrically connected to the first connector 330 and the second connector 340. For example, the first connector 330 and the second connector 340 may be connectors or pads electrically connected to a positive or negative electrode of the battery 370. In an embodiment, the first connector 330 may be referred to as a first battery connector, and the second connector 340 may be referred to as a second battery connector.

According to an embodiment, the second connector 340 may transfer at least a portion of the return current RC to the ground of the battery 370. For example, at least a portion of the return current RC generated from the communication circuit 320 may be transferred to the ground of the battery 370 through the second connector 340. In an embodiment, the ground of the second connector 340 may be joined or connected to the ground of the first connector 330. For example, the protection circuit board 383 may be connected to the second connector 340 and the first connector 330. The ground of the first connector 330 and the ground of the second connector 340 may be connected at a portion within the protection circuit board 383.

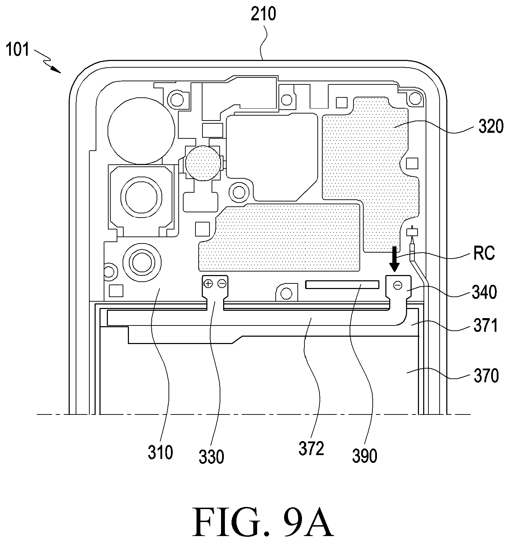

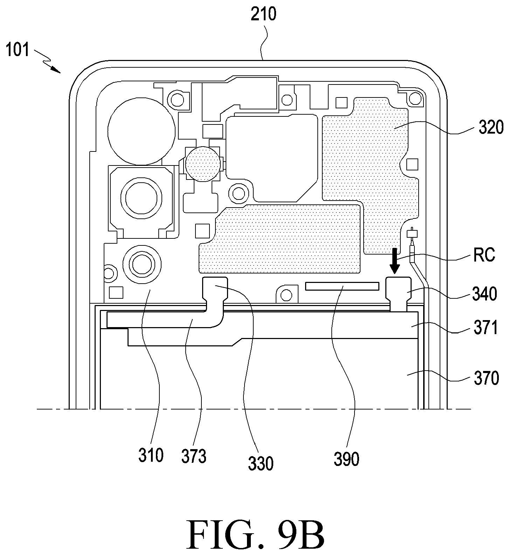

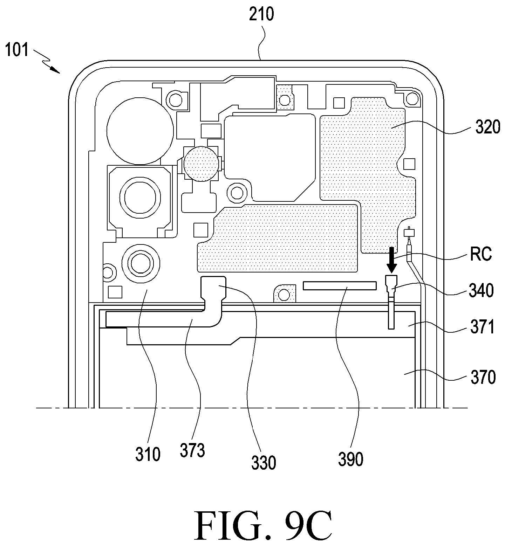

FIGS. 9A, 9B, and 9C are rear views illustrating an electronic device including a second connector according to an embodiment of the disclosure.

Referring to FIG. 9A, FIG. 9B, and/or FIG. 9C, the electronic device 101 may include the housing 210, the circuit board 310, the communication circuit 320, the first connector 330, the second connector 340, and the battery 370. The configurations of the housing 210, the circuit board 310, the communication circuit 320, the first connector 330, the second connector 340, and the battery 370 of FIG. 9A, FIG. 9B, and/or FIG. 9C may be wholly or partially the same as the configurations of the housing 210 of FIG. 4, and the circuit board 310, the communication circuit 320, the first connector 330, the second connector 340, and the battery 370 of FIG. 7A, FIG. 7B, FIG. 7C, and/or FIG. 8.

According to an embodiment, the first connector 330 may electrically connect the circuit board 310 and the battery 370. For example, the electronic device 101 may include a charging circuit 390. The charging circuit 390 may be mounted on the circuit board 310. The charging circuit 390 may control charging of the battery 370. The charging circuit may be referred to as a charging integrated circuit.

According to an embodiment, the second connector 340 may transfer at least a portion of the return current RC generated from the communication circuit 320 to the battery 370. The second connector 340 may be located between the communication circuit 320 and the battery 370. As the second connector 340 is located between the communication circuit 320 and the battery 370, the path of the return current RC may be reduced.

The shape of the second connector 340 may be implemented in various ways. The shape of the second connector 340 disclosed herein is exemplary. For example, as long as the second connector 340 provides a path for transmitting the return current RC generated from the communication circuit 320 to a ground (e.g., the battery ground or a ground 371 of the protection circuit board (e.g., the protection circuit board 383 of FIG. 8)), the structure of the second connector 340 is not limited.

According to an embodiment (e.g., FIG. 9A), the electronic device 101 may a flexible printed circuit board 372 electrically connected to the battery ground 371 of the battery 370. In an embodiment, the flexible printed circuit board 372 may electrically connect the battery 370 and the circuit board 310. For example, the flexible printed circuit board 372 may be referred to as a battery flexible printed circuit board. The first connector 330 and the second connector 340 may be connected at or extended from the flexible printed circuit board 372. According to an embodiment, the flexible printed circuit board 372 may extend from the protective circuit board 383.

According to an embodiment (e.g., FIG. 9B), the second connector 340 may be a conductive pad. The second connector 340 may contact the circuit board 310 and the battery 370 (e.g., the battery ground or the ground 371 of the protection circuit board 383). According to an embodiment, the first connector 330 may be connected to a flexible printed circuit board 373 extending from the protection circuit (e.g., the protection circuit 380 of FIG. 8).

According to an embodiment (e.g., FIG. 9C), the second connector 340 may be a conductive pin. For example, the second connector 340 may contact the circuit board 310 and the battery 370 (e.g., the battery ground or the ground 371 of the protection circuit board 383).

According to an embodiment (not shown), the second connector 340 may be a cable structure connecting the circuit board 310 and the battery 370 to each other.

Due to the return current generated from the communication circuit, noise may be generated in a component (e.g., an analog circuit) of the electronic device. As the communication circuit that may generate noise is spaced apart further from a point (e.g., a connector) connected to the ground, the length of the return current path may increase, thereby increasing noise and malfunctions in the electronic components.

However, the battery connector should be disposed adjacent to the protection circuit. Therefore, when the protection circuit and the battery connector are close, switching noise of the communication circuit may affect the communication circuit.

Further, the return current path may be adjusted using a ground having a slit formed thereon. However, as the size of the ground decreases, the resistance value of the ground and power consumption may increase, and heat may be generated.

According to an embodiment of the disclosure, an electronic device including a battery connector and a connector for providing a path of a return current from a communication circuit may be provided. Noise and malfunctions may be reduced by the electronic device.

According to an embodiment of the disclosure, an electronic device may be provided in which the length of a return current path is reduced, thereby increasing the system stability and ease of design of the electronic device.

According to an embodiment of the disclosure, an electronic device (e.g., the electronic device 101 in FIG.2) may include a housing (e.g., the housing 210 in FIG. 2), a circuit board (e.g., the circuit board 310 in FIG. 5A) disposed within the housing and including a ground layer, a battery (e.g., the battery 250 in FIG. 4) disposed within the housing and including a protection circuit (e.g., the protection circuit 380 in FIG. 8) configured to control charging, a communication circuit (e.g., the communication circuit 320 in FIG. 5A) attached on the circuit board, a first connector (e.g., the first connector 330 in FIG. 5A) disposed on the circuit board and electrically connected to the protection circuit, and a second connector (e.g., the second connector 340 in FIG. 5A) disposed on the circuit board and spaced apart from the first connector. The second connector may be closer to the communication circuit than the first connector. The second connector may be electrically connected to the ground layer of the circuit board or the battery. The electronic device 101 may supply power to the communication circuit 320 using the first connector 330, and transmit a return current (RC) generated from the communication circuit 320 to the ground layer of the circuit board 310 or a ground of the battery 250, using the second connector 340. As a point where a current is supplied to the communication circuit 320 and a point to which the return current generated from the communication circuit 320 is transmitted are separated, noise and malfunctions in the electronic device 101 may be reduced.

According to an embodiment, the communication circuit may be configured to receive power from the battery, using the first connector. The return current generated from the communication circuit may be configured to be transmitted to the ground layer of the circuit board or the battery, using the second connector.

According to an embodiment, the second connector may be connected to the ground layer of the circuit board.

According to an embodiment, the protection circuit may further include a protection circuit module electrically connected to the battery. The protection circuit module may be closer to the first connector than to the second connector.

According to an embodiment, a magnitude of the return current transmitted from the communication circuit to the second connector may be greater than a magnitude of the return current transmitted from the communication circuit to the first connector.

According to an embodiment, the circuit board may include a first area (e.g., the first area 311 in FIG. 5A) accommodating the first connector and a second area (e.g., the second area 312 in FIG. 5A) accommodating the second connector and the communication circuit.

According to an embodiment, the electronic device may further include an insulating area (e.g., the insulating area 350 in FIG. 5B or FIG. 5C) at least partially located between the communication circuit and the first connector.

According to an embodiment, the insulation area may include a first end (e.g., the first end 350a in FIG. 5B) connected to one edge of the circuit board and a second end (e.g., the second end 350b in FIG. 5B) opposite to the first end and located at another edge of the circuit board.

According to an embodiment, the second connector may be a JTAG connector.

According to an embodiment, the first connector may be connected to a negative electrode or a positive electrode of the battery.

According to an embodiment, the second connector may be electrically connected to the battery. A distance between the first connector and the protection circuit may be smaller than a distance between the second connector and the protection circuit.

According to an embodiment, the second connector may include at least one of a conductive pad, a conductive pin, a cable structure, or a connector connected to a flexible printed circuit board.

According to an embodiment, the electronic device may further include an analog circuit (e.g., the analog circuit 360 in FIG. 5A) located between the first connector and the second connector. As the analog circuit 360 is spaced apart from a path of the return current RC, malfunctions of the analog circuit may be reduced.

According to an embodiment, the electronic device may further include a digital component located between the communication circuit and the second connector. As the digital component is located on the path of the return current (e.g., the space between the communication circuit 320 and the second connector 340), design ease of the circuit board 310 may be improved.

According to an embodiment, the second connector may be located between the communication circuit and the battery. As the second connector is located between the communication circuit and the battery, the length of the path of the return current RC generated from the communication circuit 320 may be reduced.

According to an embodiment of the disclosure, an electronic device (e.g., the electronic device 101 in FIG.2) may include a housing (e.g., the housing 210 in FIG. 2), a circuit board (e.g., the circuit board 310 in FIG. 5A) disposed within the housing and including a ground layer, a battery (e.g., the battery 380 in FIG. 4) disposed within the housing and including a protection circuit (e.g., the protection circuit 380 in FIG. 8) configured to control charging, a communication circuit (e.g., the communication circuit 320 in FIG. 5A) attached on the circuit board, a first connector (e.g., the first connector 330 in FIG. 5A) disposed on the circuit board and electrically connected to the protection circuit, and a second connector (e.g., the second connector 340 in FIG. 5A) disposed on the circuit board, spaced apart from the first connector, and connected to the ground layer. The communication circuit may be closer to the second connector than to the first connector. The protection circuit may be closer to the first connector than to the second connector.

According to an embodiment, the communication circuit may be configured to receive power from the battery, using the first connector. A return current generated from the communication circuit may be configured to be transmitted to the ground layer of the circuit board, using the second connector.

According to an embodiment, a magnitude of the return current transmitted from the communication circuit to the second connector may be greater than a magnitude of the return current transmitted from the communication circuit to the first connector.

According to an embodiment, the second connector may be located between the communication circuit and the battery.

According to an embodiment, the circuit board may include a first area (e.g., the first area 311 in FIG. 5A) accommodating the first connector and a second area (e.g., the second area 312 in FIG. 5A) accommodating the second connector and the communication circuit.

The above-described electronic device including a communication circuit and a connector according to the disclosure is not limited to the forgoing embodiments, and it will be apparent to those skilled in the art that many replacements, variations, and modifications may be made within the technical scope of the disclosure.

## Claims

1. An electronic device (101) comprising:
a housing (210);
a circuit board (310) disposed within the housing and including a ground layer;
a battery (250, 370) disposed within the housing and including a protection circuit (380) configured to control charging;
a communication circuit (320) attached on the circuit board;
a first connector (330) disposed on the circuit board and electrically connected to the protection circuit; and
a second connector (340) disposed on the circuit board and spaced apart from the first connector,
wherein the second connector is closer to the communication circuit than the first connector and electrically connected to the ground layer of the circuit board or the battery.

2. The electronic device of claim 1, wherein the communication circuit is configured to receive power from the battery, using the first connector, and
wherein a return current (RC) generated from the communication circuit is configured to be transmitted to the ground layer of the circuit board or the battery, using the second connector.

3. The electronic device of claim 1 or 2, wherein the second connector is connected to the ground layer of the circuit board.

4. The electronic device of any one of the preceding claims, wherein the protection circuit is closer to the first connector than to the second connector.

5. The electronic device of any one of the preceding claims, wherein a magnitude of the return current transmitted from the communication circuit to the second connector is greater than a magnitude of the return current transmitted from the communication circuit to the first connector.

6. The electronic device of any one of the preceding claims, wherein the circuit board includes a first area (311) accommodating the first connector and a second area (312) accommodating the second connector and the communication circuit.

7. The electronic device of any one of the preceding claims, further comprising an insulating area (350) at least partially located between the communication circuit and the first connector.

8. The electronic device of claim 7, wherein the insulation area includes a first end (350a) connected to one edge of the circuit board and a second end (350b) opposite to the first end and located at another edge of the circuit board.

9. The electronic device of any one of the preceding claims, wherein the second connector is a JTAG connector.

10. The electronic device of any one of the preceding claims, wherein the first connector is connected to a negative electrode or a positive electrode of the battery.

11. The electronic device of any one of the preceding claims, wherein the second connector is electrically connected to the battery, and
wherein a distance between the first connector and the protection circuit is smaller than a distance between the second connector and the protection circuit.

12. The electronic device of any one of the preceding claims, wherein the second connector includes at least one of a conductive pad, a conductive pin, a cable structure, or a connector connected to a flexible printed circuit board.

13. The electronic device of any one of the preceding claims, further comprising an analog circuit (360) located between the first connector and the second connector.

14. The electronic device of any one of the preceding claims, further comprising a digital component located between the communication circuit and the second connector.

15. The electronic device of any one of the preceding claims, wherein the second connector is located between the communication circuit and the battery.
